Europäisches Patentamt

(19) European Patent Office

Office européen des brevets

(11) Publication number: **0 009 420**
**B1**

(12) **EUROPEAN PATENT SPECIFICATION**

(45) Date of publication of patent specification: **27.07.83**

(51) Int. Cl.³: **H 03 K 17/97, G 06 F 3/02**

(21) Application number: **79302017.3**

(22) Date of filing: **27.09.79**

(54) **A noncontacting switch device employing a differential transformer element.**

(30) Priority: **27.09.78 US 946346**

(43) Date of publication of application:
**02.04.80 Bulletin 80/7**

(45) Publication of the grant of the patent:
**27.07.83 Bulletin 83/30**

(84) Designated Contracting States:
**DE FR GB IT SE**

(56) References cited:
**DE - A - 1 906 117**
**DE - A - 1 928 294**
**DE - B - 1 118 504**
**US - A - 3 573 369**
**US - A - 3 623 081**
**US - A - 3 668 697**
**US - A - 3 683 371**
**US - A - 3 740 746**

(73) Proprietor: **Bernin, Victor M.**
**105 East Berkshire Lane Mt. Prospect**
**Illinois 60056 (US)**

(72) Inventor: **Bernin, Victor M.**
**105 East Berkshire Lane Mt. Prospect**
**Illinois 60056 (US)**

(74) Representative: **Broome, Geoffrey Edward et al,**
**KILBURN & STRODE 30 John Street**
**London, WC1N 2DD (GB)**

Courier Press, Leamington Spa, England

## A noncontacting switch device employing
## a differential transformer element

This invention relates to a differential transformer and to a keyboard employing a number of differential transformers. Keyboards used in computers, computer terminals, calculators, control panels, telephone devices, etc., have often been of the mechanical types and more recently solid state noncontacting types. The mechanical types suffered from mechanical wear, corrosion of contacts, etc., which limited their useful life and reliability. The solid state types, which were generally of the electromagnetic, capacitive, photoelectric, or Hall Effect types, suffer from either high cost, marginal performance, excess power consumption, susceptibility to environmental factors, and sometimes unreliability. The differential transformer provided by the present invention represents an advancement in the art of keyboard switching in terms of improved performance and reliability, and reduced cost.

German Patent Specification No. 1118504 discloses an array of differential transformers each of which comprises two primary windings and two secondary windings in close proximity to the primary windings, each primary winding being opposite to and aligned with one of the secondary windings to define first and second primary-secondary winding pairs, the primary windings being interconnected and the secondary windings being interconnected to form a differential transformer configuration wherein the output signal voltage from the interconnected secondary windings represents the difference in the magnetic coupling between the first and second primary-secondary winding pairs, and a mutual inductance changing member which is movable from a position outside a common winding bore defined by one of said primary-secondary winding pairs to a position within said bore to effect a change in mutual inductance and hence the coupling of said one of said primary-secondary winding pairs with a resulting change in the balance of the differential transformer and the signals coupled by the primary-secondary winding pairs which signifies a switching operation.

According to the present invention such a differential transformer for providing a switch function is characterised in that the two primary windings lie in, and are interconnected in, the same first plane and the two secondary windings lie in, and are interconnected in, a second plane parallel and in close proximity to the first plane, and, as a consequence, the two primary-secondary winding pairs have respective axes and the mutual inductance changing member is movable from a position outside a common winding bore defined by one *only* of said winding pairs to a position within said bore, the other primary-secondary winding pair having no mutual inductance changing member associated therewith.

U.S. Specification No. 3668697 discloses a differential transformer switch having two primary windings and two secondary windings and mutual coupling changing means operated by a key to change the coupling between only one of the primary-secondary winding pairs. The switch requires a network or element external to the switch to maintain its balance.

The basic advantages of a differential transformer according to the present invention, stem from its simplicity, its very low cost, high reliability, and due to the high degree of transformer balance that can be maintained on a printed board, a high degree of switch performance in terms of a high on/off ratio or dynamic range is provided.

In an embodiment of the present invention, a keyboard is comprised of an array of such differential transformers, each consisting of four identical printed circuit coils, a switch assembly incorporating a switch stem, a return spring, a magnetic core and a key top. When a keyswitch is depressed the magnetic core will be positioned in the centre of a primary-secondary coil pair, one half of the differential transformer element, changing the differential transformer from a balanced or "off" state to an unbalanced or "on" state. The two primary coils of the differential transformer element are connected in series opposing and the secondaries in series aiding. When a signal is applied to an undepressed switch the signal will not appear at the output terminals of the switch, since the differential transformer is in a balanced state. Depressing the switch unbalances the transformer permitting a drive or excitation signal to be coupled through to the output terminals of the differential transformer. The two primary coils are printed on one side of a printed circuit board and directly opposite on the other side of the board is printed the secondary coils, with a hole provided through the board through the centre of one primary-secondary pair for insertion of the magnetic actuator. The switch assembly or mechanism containing the switch keytop, magnetic core, etc., is then mounted directly above the differential transformer coils. The network which interconnects the secondary coils is printed on the printed circuit board at the same time as the coils are printed. The primary coils and interconnecting network are printed in the same manner.

In the preferred embodiment the keyboard switch array is interconnected and organized into an X—Y matrix in which the primary coils are arranged into columns or drive lines along an X axis, and the secondary coils are arranged into rows or sense lines along a Y axis. This matrix can then be scanned by conventional means for encoding of switches and implementing various multi-key rollover circuits, etc. When implementing an N-key rollover circuit employing the differential transformer type switch diodes for isolation purposes are not required as is often the case with this type circuit. The differential transformer type switch is a self-contained and independent type switch, and does not require another switch, external components or circuitry to maintain its balance or perform its function.

In order to promote a fuller understanding of the above, and other, aspects of the invention, some embodiments will now be described, by way of example only, with reference to the accompanying drawings in which:—

Figure 1 shows a basic switch element using a ferrite core in a balanced and in an unbalanced state,

Figure 2 is a typical switch module design,

Figure 3 shows a secondary interconnection of an X—Y matrix, and

Figure 4 shows the primary coil interconnections in an X—Y matrix.

The basic switch element embodied in this invention is a differential electromagnetic transformer which can exist in either a balanced or in an unbalanced state. The switch is so designed and structured that a switch actuation will result in changing the switch from a balanced "off" condition to an unbalanced or "on" condition. The differential transformer consists of two identical simple transformers, i.e., a single primary winding and a single secondary winding transformer, with the primary windings interconnected in series opposing and the secondaries in a series aiding configuration. Under these conditions an excitation voltage applied to primary windings of the differential transformer will cancel out in the secondary windings or the output terminals of the transformer element, since the differential transformer is in a balanced state. To unbalance the differential transformer, the electrical characteristics of one of the two simple transformers involved is modified, i.e., their coupling is either increased or decreased. An excitation voltage then applied to the input or primary windings will not cancel out and a signal will appear at the output terminals of the switch. The advantage of a differential transformer over a simple transformer switch configuration is due to the fact that a high degree of balance can be obtained in a printed coil type differential transformer, which translates to a switch with a high on/off ratio or dynamic range which is a desirable switch characteristic. This fact, plus the fact that printed coils are very inexpensive, results in a switch design that is relatively high in performance and low in cost.

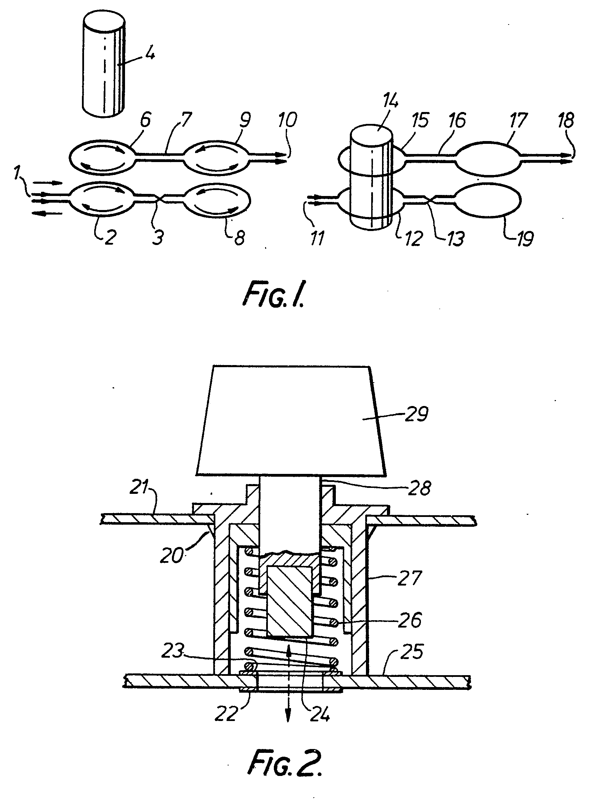

Figure 1 shows a basic differential transformer switch element consisting of a movable ferrite magnetic core 4, two planr or flat primay coils 2 and 8, two planar secondary coils 6 and 9. The two secondary coils are connecting in series aiding at 7, and the two primary coils 2 and 8 interconnected in series opposing by means of a crossover at 3. An excitation voltage is applied to the primary coils at 1, and the output signal will appear at the secondary outout at 10. Figure 1 shows the switch in a balanced or "off" state since the core 4 does not affect winding 2 and 6.

Figure 1 also shows the switch in an unbalanced or "on" state since the core 14 is in the centre of coils 15 and 12 magnetically linking these two coils, thereby increasing their mutual inductance and therefore their coupling. In Figure 1, the voltage across each secondary coil 6 and 9 is equal but of opposite phase and therefore cancel each other. With the core positioned inside windings 15 and 12, the voltage across winding 15 has increased due to the increased coupling between windings 15 and 12, with the result that the two voltages do not cancel each other and a net voltage appears across the output terminals of the differential transformer at 18. The magnetic core 4 of Figure 1 can be replaced by a shorted turn. In the shorted turn type switch an unbalance is created by reducing the magnetic coupling between two windings rather than by increasing it by means of ferrite core. The disadvantage of a shorted turn type switch as compared to a magnetically permeable core such as a ferrite core is the lower output that results, all other conditions being equal.

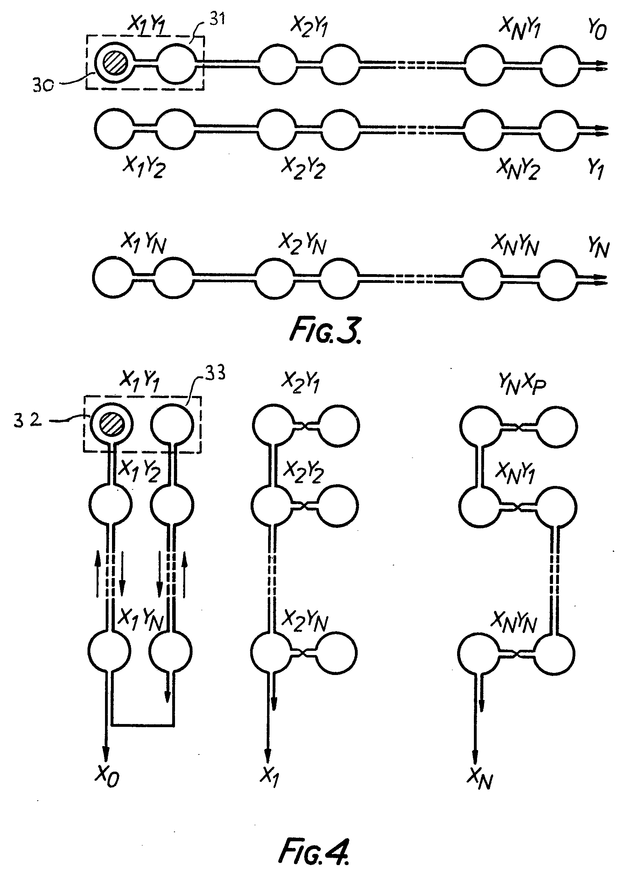

The differential transformer switch embodying this invention is well adapted to various switch matrix designs, which include an X—Y type scanning matrix. This type matrix provides an efficient and effective means for encoding keyboard switches, and providing various forms of multi-key rollover functions. Figure 3 shows the manner in which the secondary coils are interconnected and arranged into rows or sense lines along a Y axis, and Figure 4 shows how the corresponding primary coils are interconnected and arranged into columns or drive lines. The circuits shown in Figure 3 can be visualized as being superimposed on the circuit shown in Figure 4, but separated by a non-conductive substrate or insulated board, such that the secondary coils fall on top of their corresponding primary coils, i.e., secondary coil 30 on top of primary coil 32 and 31 on top of 33. The secondary coils in a given row or sense line are connected in a series aiding configuration, and the primary coils in a given column or drive line are also connected in a series arrangement but with the currents in the primary windings of a given switch oppositely phased. Figure 4 shows several circuit configurations which will provide oppositely phased primary currents.

The transformer coils and their interconnecting network are constructed in a planar form, i.e., the coils and network lie flat in a plane. The purpose of constructing these circuits in the manner is that it allows for very low cost fabrication techniques to be employed, principally printed circuit board and thick film screening techniques. An additional benefit from these techniques is that highly accurate and highly repeatable conductive patterns are provided which translates into highly balanced differential transformers and therefore switches with a high on/off ratio or dynamic range.

The primary and secondary circuits lie in separate but parallel planes and generally as close as possible to one another. In a double sided printed circuit board design, the primary and secondary circuit would be printed on opposite sides of the board. Thick filmed screening techniques allow the two patterns to be screened on opposite sides or on the same side. The paired primary and secondary coils will lie on the same axis and holes will be provided through the board through the centre of the paired coils as required for the insertion of a magnetic switch actuator.

Other fabrication techniques can be employed. The various sense and drive lines, as an example, can be formed from conductive wires into "wireforms". These wireforms can then be snapped into position at the base of appropriately designed switch housings. Instead of wireforms, thin metal strips can be punched to form the correct circuit patterns and similarly snapped into an appropriately designed switch housing. Employing wire wrap techniques is another possible approach. Wires can be wrapped around the base of appropriately designed switch housings to form the coils, and then routed with wires to the next switch position to form the interconnecting network.

Figure 2 shows a typical switch module design incorporating the basic differential transformer switch element which consists of a keycap or button 29, keystem 28 which moves in a vertical axis and incorporating a ferrite magnetic core 24, a switch housing 27, and a return spring 26. The switch housing 27 includes a snap in tab 20 and snaps into a chassis 21, and guide pins (not shown) locate the housing 27 on the printed circuit board 25. The printed circuit board 25 has the primary coils 22 printed on the bottom side and the secondary coils 23 printed on the top side of the printed circuit board 25. When the switch is actuated the switch button is depressed thereby moving the switch stem 28 downward such that the magnetic core 24 is positioned inside the primary and secondary coils 23 and 22. The switch stem design can incorporate a shorted turn instead of a magnetic core.

An array of keyboard switches organized into a two dimensional X—Y matrix can conveniently be scanned electronically. This is a conventional and most effective configuration for encoding the switches and providing various multi-key rollover function. The drive lines $X_o$ through $X_n$ are sequentially scanned by current pulses, representing the least significant bits of timing information, and the sense lines $Y_o$ through $Y_n$ are scanned by a multiplexer, in accordance with the most significant bits of timing information. The basic timing information is provided by a binary counter which is advanced by a master clock. The output from the multiplexer is a single channel signal, and an output pulse will appear for each keyswitch depressed in the matrix in each frame interval. A frame interval is defined as the period required to scan once through the matrix. Each output pulse from the multiplexer will occupy a unique time slot in the frame interval corresponding to a unique code from the binary counter. This pulse will constitute a strobe signal for enabling a storage register, etc.

**Claims**

1. A differential transformer for providing a switch function comprising two primary windings (2, 8) and two secondary windings (6, 9) in close proximity to the primary windings, each primary winding being opposite to and aligned with one of the secondary windings to define first and second primary-secondary winding pairs (2, 6; 8, 9), the primary windings being interconnected and the secondary windings being interconnected to form a differential transformer configuration (FIGURE 1) wherein the output signal voltage (10, 18) from the interconnected secondary windings, represents the difference in the magnetic coupling between the first and second primary-secondary winding pairs, and comprising a mutual inductance changing member (4) which is movable from a position outside a common winding bore defined by one of said primary-secondary winding pairs to a position within said bore to effect a change in mutual inductance and hence the coupling of said one of said primary-secondary winding pairs with a resulting change in the balance of the differential transformer and the signals coupled by the primary-secondary winding pairs which signifies a switching operation; characterised in that the two primary windings lie in, and are interconnected in, the same first plane and the two secondary windings lie in, and are interconnected in, a second plane parallel and in close proximity to the first plane, and, as a consequence, the two primary-secondary winding pairs have respective axes and the mutual inductance changing member (4) is movable from a position outside a common winding bore defined by one *only* of said winding pairs to a position within said bore, the other primary-secondary winding pair having no mutual inductance changing member associated therewith.

2. A differential transformer as claimed in Claim 1 comprising a flat circuit board (25) having two substantially parallel surfaces with the primary windings being disposed on one surface and with the secondary windings being disposed on the other surface and in which the movable inductance changing member reciprocates within a circuit board aperture.

3. A differential transformer as claimed in Claim 1 or Claim 2 in which each primary and secondary winding has no more than a single turn.

4. A differential transformer as claimed in any preceding claim in which said mutual inductance changing member comprises a magnetic core.

5. A differential transformer as claimed in any of Claims 1—3, in which said mutual inductance changing member comprises a shorted winding.

6. A differential transformer as claimed in any preceding claim in which said primary and second windings are formed as part of and on respective opposite surfaces of a printed circuit board (25).

7. A keyboard including an array of differential transformers each as claimed in any preceding claim, the array of differential transformers being electrically interconnected to form a two dimensional X—Y matrix by connecting the output terminals of the differential transformers in row sense lines which have a unique position along a Y axis (FIGURE 1) and by connecting the input terminals in column drive lines which have unique position along an X axis (FIGURE 4).

8. A keyboard as claimed in Claim 7 in which each row sense line is formed by a series connection of all the secondary windings of the differential transformers in that row, and in which each column drive line is formed by a series connection of all of the primary windings of the differential transformers in that column.

## Revendications

1. Transformateur différentiel pour remplir une fonction de commutation, comprenant deux enroulements primaires (2, 8) et deux enroulements secondaires (6, 9) placés à proximité étroite des enroulements primaires, chaque enroulement primaire étant opposé à et aligné avec un des enroulements secondaires de façon à définir une première et une seconde paire d'enroulements primaire-secondaire (2,6; 8,9), les enroulements primaires étant reliés entre eux et les enroulements secondaires étant reliées entre eux pour former une configuration de transformateur différentiel (Fig. 1) dans laquelle la tension de sortie (10, 18) des enroulements secondaires reliés entre eux représente la différence de couplage magnétique entre la première et la seconde paire d'enroulements primaire-secondaire, et comprenant un élément de modification d'inductance mutuelle (4) qui est déplaçable depuis une position situé à l'extérieur d'un trou d'enroulement commun défini par une desdites paires d'enroulements primaire-secondaire jusque dans une position située à l'intérieur dudit trou en vue de produire une modification d'inductance mutuelle, et par conséquent agir sur le couplage de ladite paire d'enroulements primaire-secondaire provoquant une variation résultante sur l'équilibre du transformateur différential et par conséquent

sur les signaux couplés par les paires d'enroulements primaire-secondaire ce qui traduit une opération de commutation, caractérisée en ce que les deux enroulements primaires sont situés et interconnectés dans le même premier plan, ce que que les deux enroulements secondaires sont situés et interconnectés dans un second plan parallèle au premier plan et placés à proximité étroite de celui-ci, en ce qu'en conséquence les deux paires d'enroulements primaire-secondaire comportent des axes respectifs, et en ce que l'élément de modification d'inductance mutuelle 4 est déplaçable depuis une position située à l'extérieur d'un trou d'enroulement commun défini seulement par une desdites paires d'enroulement jusque dans une position située à l'intérieur dudit trou, l'autre paire d'enroulements · primaire-secondaire n'ayant pas d'élément de modification d'inductance mutuelle.

2. Un transformateur différentiel selon la revendication 1, caractérisé en ce qu'il comprend une plaquette plane à circuits (25) comportant deux surfaces réellement parallèles, les enroulements primaires étant disposés sur une surface tandis que les enroulements secondaires sont disposés sur l'autre surface, et en ce que l'élément mobile de modification d'inductance dispose d'un mouvement de va-et-vient à l'intérieur d'une ouverture de la plaquette à circuits.

3. Transformateur différentiel selon l'une des revendications 1 ou 2, caractérisé en ce que chaque enroulement primaire et secondaire ne comporte pas plus d'une seule spire.

4. Transformateur différentiel selon l'une quelconque des revendications précédentes, caractérisé en ce que ledit élément de modification d'inductance mutuelle comprend un noyau magnétique.

5. Transformateur différential selon l'une quelconque des revendications 1 à 3, caractérisé en ce que ledit élément de modification d'inductance mutuelle comprend un enroulement court-circuité.

6. Transformateur différentiel selon l'une quelconque des revendications précédentes, caractérisé en ce que lesdits enroulements primaires et secondaires sont réalisés sous forme d'une partie, et sur des surfaces opposées respectives, d'une plaquette à circuits imprimés (25).

7. Un clavier à touches comportant un ensemble de transformateurs différentiel selon l'une quelconque des revendications précédentes, les transformateurs différentiels dudit ensemble étant interconnectés électriquement de façon à former une matrice X—Y bi-dimensionnelle par connexion des bornes de sortie des transformateurs différentiels en rangées ou lignes de détection qui ont une position unique le long d'un axe Y (Figure 1) et par connexion des bornes d'entrée en colonnes ou lignes d'activation qui ont une position unique le long d'un axe X (Figure 4).

8. Clavier à touches selon la revendication 7, caractérisé en ce que chaque rangée ou ligne de détection est formée par une connexion en série de tous les enroulements secondaires du transformateurs différentiels de ladite rangée, et en ce que chaque colonne ou ligne d'activation est formée par une connexion en série de tous les enroulements primaires des transformateurs différentiels de cette colonne.

**Patentansprüche**

1. Differentialtransformator zum Erzeugen einer Schaltfunktion, mit zwei Primärwicklungen (2, 8) und zwei in geringem Abstand von ihnen angeordneten Sekundärwicklungen (6, 9), wobei jede Primärwicklung in Deckungsstellung mit einer der Sekundärwicklungen und ihr gegenüber angeordnet ist, um erste und zweite Primär-/Sekundärwicklungs-Paare (2,6; 8,9) zu bilden, und die Primär- und die Sekundärwicklungen je untereinander verbunden sind, um eine Differentialtransformator-Konfiguration (Fig. 1) zu bilden, in welcher die Ausgangssignalspannung (10, 18) aus den untereinander verbundenen Sekundärwicklungen die Differenz in der magnetischen Kopplung zwischen den ersten und zweiten Primär-/Sekundärwicklungs-Paaren darstellt, und mit einem die Gegeninduktivität verändernden Bauteil (4), das aus einer Stellung außerhalb einer gemeinsamen Wicklungsbohrung, die von einem der Primär-/Sekundärwicklungs-Paare gebildet ist, in eine Stellung innerhalb dieser Bohrung bewegbar ist, um die Gegeninduktivität und damit die Kopplung des einen Primär-/Sekundärwicklungs-Paares zu ändern, woraus sich eine Änderung des Symmetriezustandes des Differentialtransformators und der durch die Primär-/Sekundärwicklungs-Paare gekoppelten Signale ergibt, was einen Schaltvorgang bedeutet, dadurch gekennzeichnet, daß

— die beiden Primärwicklungen in derselben ersten Ebene angeordnet und untereinander verbunden sind und die beiden Sekundärwicklungen in einer in geringem Abstand zur ersten Ebene parallelen zweiten Ebene angeordnet und untereinander verbunden sind, derart, daß die beiden Primär-/Sekundärwicklungs-Paare zugehörige Achsen aufweisen,

— das die Gegeninduktivität verändernde Bauteil (4) aus einer Stellung außerhalb einer gemeinsamen Wicklungsbohrung, die von nur *einem* der Wicklungspaare gebildet ist, in eine Stellung innerhalb dieser Bohrung bewegbar ist,

— und dem anderen Primär-/Sekundärwicklungs-Paar kein die Gegeninduktivität veränderndes Bauteil zugeordnet ist.

2. Differentialtransformator nach Anspruch 1, dadurch gekennzeichnet, daß eine ebene Schaltungsplatte (25) mit zwei zumindest annähernd parallelen Flächen vorgesehen ist, wobei die Primärwicklungen auf der einen und die Sekundärwicklungen auf der anderen Fläche angeordnet sind und das bewegliche die Gegeninduktivität verändernde Bauteil in einer Schaltungsplattenöffnung hin- und herbewegbar ist.

3. Differentialtransformator nach Anspruch 1 oder 2, dadurch gekennzeichnet, daß jede Primär- und Sekundärwicklung nicht mehr als eine einzige Windung aufweist.

4. Differentialtransformator nach einem der Ansprüche 1 bis 3, dadurch gekennzeichnet, daß das die Gegeninduktivität verändernde Bauteil von einem magnetischen Kern gebildet ist.

5. Differentialtransformator nach einem der Ansprüche 1 bis 3, dadurch gekennzeichnet, daß das die Gegeninduktivität verändernde Bauteil von einer kurzgeschlossenen Windung gebildet ist.

6. Differentialtransformator nach einem der Ansprüche 1 bis 5, dadurch gekennzeichnet, daß die Primär- und Sekundärwicklungen als Teil von und auf zugehörigen, einander abgewandten Flächen einer gedruckten Schaltungsplatte (25) ausgebildet sind.

7. Tastatur mit einer Gruppe regelmäßig angeordneter Differentialtransformatoren je nach einem der Ansprüche 1 bis 6, wobei die Differentialtransformatoren der Gruppe zur Bildung einer zweidimensionalen X—Y—Matrix untereinander elektrisch so verbunden sind, daß ihre Ausgangsklemmen lesezeilenweise verbunden sind und dabei jede Zeile auf der Y-Achse eine eineindeutige Stellung hat (Fig. 1) und die Eingangsklemmen ansteuerspaltenweise verbunden sind und dabei jede Spalte eine eineindeutige Stellung auf der X-Achse (Fig. 4) hat.

8. Tastatur nach Anspruch 7, dadurch gekennzeichnet, daß jede Lesezeile von einer Hintereinanderschaltung aller Sekundärwicklungen der in dieser Zeile angeordneten Differentialtransformatoren und jede Ansteuerspalte von einer Hintereinanderschaltung aller Primärwicklungen der in dieser Spalte angeordneten Differentialtransformatoren gebildet ist.

FIG. 1.

FIG. 2.

FIG.3.

FIG.4.